# EUROPEAN PATENT APPLICATION

(11) **EP 2 432 031 A2**
(43) Date of publication of application: **21.03.2012**
(21) Application number: 11181364.8
(22) Date of filing: 15.09.2011
(51) Int. Cl.: H01L 31/048

(54) **Photovoltaic module**

(30) Priority: 16.09.2010 JP 2010207983
(71) Applicant: Fuji Electric Co., Ltd., Kawasaki-shi 210-9530 (JP)
(72) Inventor: Watanabe, Kazuyo, Kawasaki-shi, 210-9530 (JP); Wada, Takehito, Kawasaki-shi, 210-9530 (JP)
(74) Representative: Appelt, Christian W.

(57) **Abstract**

The flame resistance of a substrate structure photovoltaic module that uses a light, flexible film substrate is improved. A photovoltaic module includes a substrate structure photovoltaic cell wherein a metal electrode layer, a thin film photoelectric conversion layer, and a transparent electrode layer are formed stacked on a light receiving surface side of a film substrate, light receiving surface side and non-light receiving surface side sealing member layers stacked on a light receiving surface side and non-light receiving surface side of the photovoltaic cell, and directly joined to each other in the periphery of the photovoltaic cell, that essentially seal the photovoltaic cell, a front surface protection layer joined to the light receiving surface side of the photovoltaic cell across the light receiving surface side sealing member layer, and a rear surface protection layer joined to the non-light receiving surface side of the photovoltaic cell across the non-light receiving surface side sealing member layer, wherein the front surface protection layer is formed from a transparent resin film, and a glass coating layer is formed on a light receiving surface side thereof.

## Description

### BACKGROUND OF THE INVENTION

### 1. Technical Field

The present invention relates to a photovoltaic module, and in particular, relates to a photovoltaic module that uses a flexible thin metal plate or synthetic resin film on a substrate on which is formed stacked a thin film photoelectric conversion element.

### 2. Related Art

A superstrate structure photovoltaic module wherein light falls incident through a substrate, and a substrate structure photovoltaic module wherein light falls incident directly onto a photoelectric conversion element on a substrate, without passing through the substrate, are widely known as photovoltaic modules. Then, a glass substrate, metal substrate, synthetic resin substrate, or the like, is used as the substrate and, although the kind of substrate is not limited in the case of a substrate structure, in the case of a superstrate structure, it is necessary to use a glass or transparent synthetic resin substrate, or the like, with good light transmittance.

As a synthetic resin film substrate or thin plate metal substrate (hereafter called simply a film substrate) is light in comparison with a glass substrate, a photovoltaic module using a film substrate places less burden on the structure when installed on the roof, outside wall, or the like, of a building, can be installed in an existing building without doing reinforcement work and, as it can be incorporated in the building itself by being configured as a module integrated with the building material of the roof, or the like, there is an advantage in that transportation to the place of installation, and installation work, can also be easily carried out.

Also, as it is possible to manufacture the photovoltaic cell using a roll-to-roll type of deposition process by using a flexible, belt-like film substrate, as well as naturally being advantageous in terms of manufacturing cost, it can also be installed along a curved roof or wall surface of a gymnasium, or the like, as there is also flexibility at the module level, and various applications are expected.

A structure serially connected via through holes is commonly known as a substrate structure photovoltaic cell using a film substrate (for example, JP-A-6-342924). With this structure, as shown in Fig. 4B, a metal electrode layer 12, photoelectric conversion layer 13 formed from a p-i-n junction structure semiconductor, and transparent electrode layer 14 are formed stacked on the front surface of a film substrate 11, and a connection electrode layer 15 is formed on the rear surface of the film substrate 11, after which, by each of the layers 12, 13, and 14 on the front surface side and the connection electrode layer 15 on the rear surface side being patterned into multiple unit cells 1a in positions (18 and 19) not mutually aligned, each unit cell 1a is serially connected via a current collection hole 16 drilled in a region in which the transparent electrode layer 14 is formed, a connection hole 17 drilled in a region in which the transparent electrode layer 14 is not formed, and each connection electrode layer 15.

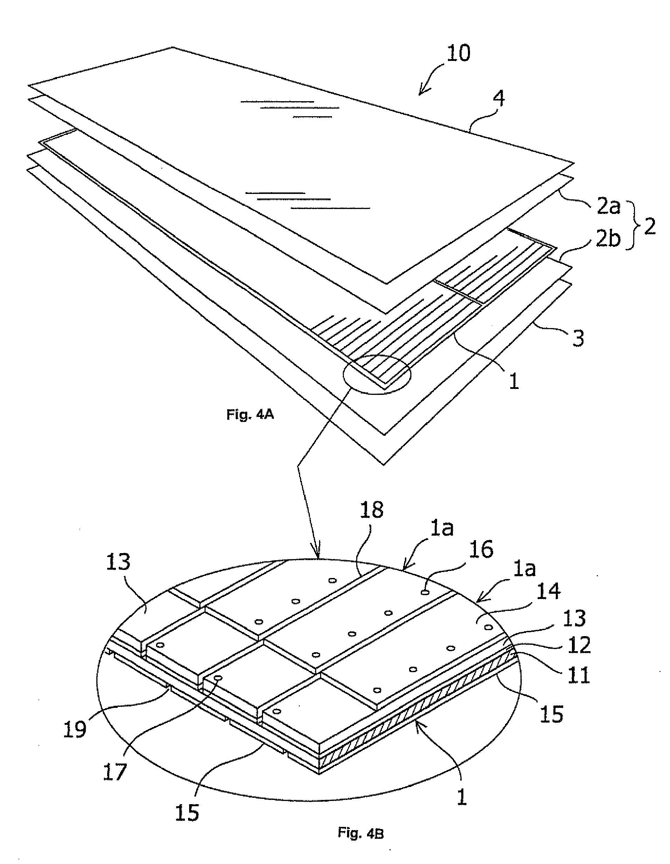

As the photovoltaic cell 1 as it is has no weather resistance, a front surface protection member 4 and rear surface protection member 3 are stacked across thermal adhesive sheets 2a and 2b on the front and rear surface respectively, as shown in Fig. 4A, and are integrally laminated by heating after vacuuming in an unshown vacuum lamination device, thus forming a photovoltaic module 10 (for example, JP-A-2004-311571). A transparent resin film is used for the front surface protection member 4, and a steel plate, resin sheet, or the like, is used for the rear surface protection member 3 in accordance with the application.

As the sealing members sealing the photovoltaic cell are flammable when a resin film is used as the front surface protection member in order to provide the photovoltaic module with weather resistance, there is a problem in that the flame resistance of the photovoltaic module as a whole decreases. Also, in order to utilize the advantages of lightness and flexibility of a photovoltaic module using a film substrate, it is productive to provide flame resistance commensurate with a glass substrate photovoltaic module.

### SUMMARY OF THE INVENTION

The invention, bearing in mind the heretofore described kind of problem, has been contrived with an object of improving the flame resistance of a substrate structure photovoltaic module that uses a light, flexible film substrate.

In order to achieve the object, in a first aspect of the invention, a photovoltaic module includes a substrate structure photovoltaic cell wherein a metal electrode layer, a thin film photoelectric conversion layer, and a transparent electrode layer are formed stacked on a light receiving surface side of a film substrate, light receiving surface side and non-light receiving surface side sealing member layers stacked on a light receiving surface side and non-light receiving surface side of the photovoltaic cell, and directly joined to each other in the periphery of the photovoltaic cell, that essentially seal the photovoltaic cell, a front surface protection layer joined to the light receiving surface side of the photovoltaic cell across the light receiving surface side sealing member layer, and a rear surface protection layer joined to the non-light receiving surface side of the photovoltaic cell across the non-light receiving surface side sealing member layer, wherein the front surface protection layer is formed from a transparent resin film, and a glass coating layer is formed on a light receiving surface side thereof.

According to the heretofore described configuration, flame resistance as a photovoltaic module is increased by the glass coating layer of the outermost surface, while still maintaining the advantages as a light, flexible photovoltaic module, and deformation caused by the heat of the front surface protection layer, sealing member layers, and film substrate, and accompanying combustion, are suppressed.

Also, in a second aspect of the invention, the front surface protection layer in the heretofore described photovoltaic module is formed from a glass coating layer formed on the light receiving surface side sealing member layer. In this aspect, along with flame resistance as a photovoltaic module being increased by the glass coating layer, there are advantages in that weather resistance is obtained from the glass coating layer and light receiving surface side sealing member layer, and manufacturing cost can be reduced in comparison with the photovoltaic module of the first aspect.

Furthermore, in a third aspect of the invention, the front surface protection layer in the heretofore described photovoltaic module being formed from a transparent resin film, and a glass coating layer being formed on the light receiving surface of the photovoltaic cell, the front surface protection layer is joined to the light receiving surface side of the photovoltaic cell across the light receiving surface side sealing member layer and glass coating layer. In this aspect, although the flame resistance of the module front surface depends on the resin film of the front surface protection layer, it is possible to improve the flame resisting performance of the module as a whole by deformation caused by the heat of the film substrate, and accompanying combustion, being suppressed.

In each aspect of the invention, it is preferable that the glass coating layer is formed by applying a room temperature curing type glass coating material. In this aspect, as it is possible to form the glass coating layer by applying the glass coating material on the outermost surface of the photovoltaic module for which the lamination process has been completed, using a spray method or roller method, and allowing it to cure at room temperature, there is little additional equipment cost. Also, it is also possible to form the glass coating layer at the place of installation of the photovoltaic module.

As heretofore described, according to the invention, it is possible to improve, at low cost, the flame resistance of a substrate structure photovoltaic module that uses a film substrate, while maintaining the characteristics of the photovoltaic module of being light and flexible, which is advantageous when applying to a variety of uses.

### BRIEF DESCRIPTION OF THE DRAWINGS

Fig. 1 is a schematic sectional view showing a photovoltaic module of a first embodiment of the invention;
Fig. 2 is a schematic sectional view showing a photovoltaic module of a second embodiment of the invention;
Fig. 3 is a schematic sectional view showing a photovoltaic module of a third embodiment of the invention; and
Fig. 4A is an exploded perspective view showing a photovoltaic module on which the invention is predicated, and Fig. 4B is a schematic main portion enlarged perspective view showing a photovoltaic cell of the photovoltaic module.

### DETAILED DESCRIPTION OF THE EMBODIMENTS

Hereafter, a detailed description will be given, while referring to the drawings, of embodiments of the invention. In the following description, a description may be omitted by attaching the same or corresponding reference numerals or characters to configurations that are the same or correspond in each embodiment.

### First Embodiment

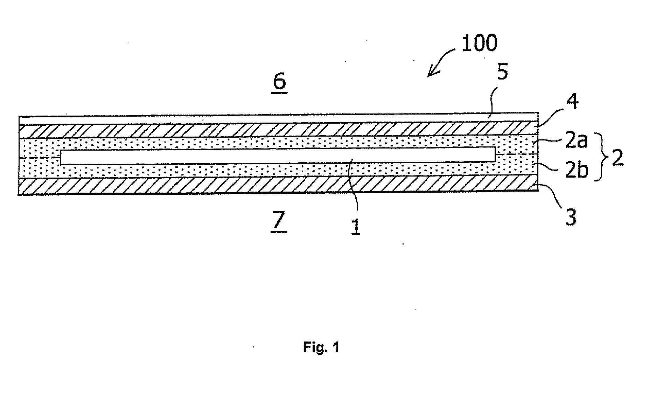

A photovoltaic module 100 of a first embodiment according to the invention is such that while a front surface protection layer 4 is joined to a light receiving surface side 6 of a substrate structure photovoltaic cell 1 across a sealing member layer 2a, a rear surface protection layer 3 is joined to a non-light receiving surface side 7 of the photovoltaic cell 1 across a sealing member layer 2b, and furthermore, a glass coating layer 5 is formed on an outermost surface of the front surface protection layer 4, as shown in Fig. 1.

The photovoltaic cell 1 is such that while a metal electrode layer 12 of Ag, Al, or the like, is deposited on the front surface of a film substrate 11, a photoelectric conversion layer 13 formed from a p-i-n junction structure amorphous silicon semiconductor film is deposited on the metal electrode layer 12, and furthermore, a transparent electrode layer 14 formed from ITO, ZnO, or the like, is formed on the photoelectric conversion layer 13, a connection electrode layer 15 of Ag, Al, or the like, is deposited on the rear surface of the film substrate 11, as shown in Fig. 4B. A plurality of photoelectric conversion layers 13 may be provided. Each deposition step is implemented by a chemical vapor deposition such as a plasma CVD or physical vapor deposition such as a sputtering, using a roll-to-roll type of deposition process using the belt-like film substrate 11.

Although a highly heat resistant polyimide film is optimal as the film substrate 11, it is also possible to use another plastic film. Connection holes 17 are drilled in advance in a predetermined arrangement in the film substrate 11, and current collection holes 16 are drilled in a predetermined arrangement after the formation of the front and rear electrode layers 12 and 15. By each of the layers 12, 13, and 14 on the front surface side of the film substrate 11 and the connection electrode layer 15 on the rear surface side being divided into multiple unit cells 1a by patterning grooves 18 and 19 formed by laser processing in positions not mutually aligned, there is formed a serially connected structure wherein each unit cell 1a is connected via the current collection hole 16 drilled in a region in which the transparent electrode layer 14 is formed, the connection hole 17 drilled in a region in which the transparent electrode layer 14 is not formed, and each connection electrode layer 15. The hole drilling steps and laser processing steps are also implemented using a roll-to-roll process.

When modularizing the photovoltaic cell 1, firstly, a provisional lamination process is implemented using an unshown lamination device. That is, the slightly larger (wider) sealing members 2a and 2b and an unshown release sheet are stacked on the light receiving surface side 6 and non-light receiving surface side 7 of the photovoltaic cell 1 unrolled from a roll, and integrally laminated by passing through a laminating roll pre-heated to a predetermined temperature. The sealing members 2a and 2b are formed from a transparent resin sheet having heat bondability and, for example, an ethylene-vinyl acetate copolymer (EVA) film is optimally used. The photovoltaic cell 1 laminated with the sealing members 2a and 2b is cut into individual modules. In the example shown in Fig. 4A, one module is configured by two serially connected structures being connected in parallel.

Next, in a condition in which the front surface protection member 4 formed from a transparent resin film is stacked on the light receiving surface side sealing member 2a and the rear surface protection member 3 is stacked below the non-light receiving surface side sealing member 2b, a photovoltaic module (sub-module 10) wherein the front surface protection member 4 and rear surface protection member 3 are integrated with the photovoltaic cell 1 across the sealing members 2a and 2b is configured by housing in a batch type vacuum lamination device, and carrying out a vacuum lamination process under predetermined processing conditions.

In terms of transparency, weather resistance, heat resistance, and shock resistance, a fluorine series resin film of an ethylene tetrafluoroethylene copolymer (ETFE), or the like, is optimal as the resin film used for the front surface protection member 4. Also, as the rear surface protection member 3, it being possible to select a material such as a metal plate, fiber-reinforced resin plate, resin plate, or resin sheet in accordance with the application, for example, a coated steel plate based on a Galvalume steel plate, which has superior strength and corrosion resistance, or a resin sheet of ETFE, PET, or the like, is optimal.

Finally, the glass coating layer 5 is formed on the outermost surface of the front surface protection member 4 of the photovoltaic module (sub-module 10) for which the lamination process has been completed as heretofore described, thus configuring the photovoltaic module 100. The formation of the glass coating layer 5 is carried out by applying the glass coating material 5. By using a room temperature curing type glass coating material, it is possible to form the glass coating layer 5 by applying the material using a spray method or roller method, and allowing it to cure at room temperature. It is possible to optimally use a glass coating material based on perhydropolysilazane (PHPS), which includes no organic component and with which it is possible to form a glass film with a moisture curing reaction, as the room temperature curing type glass coating material. The glass coating layer 5 may also be thickened by carrying out the application and curing of the glass coating material a plurality of times.

### Second Embodiment

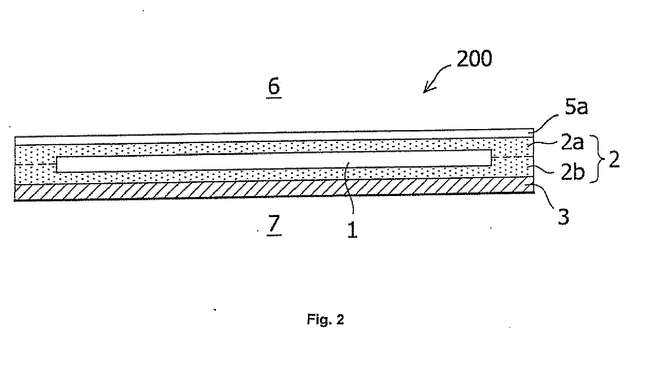

A photovoltaic module 200 of a second embodiment according to the invention is such that a glass coating layer 5a is formed directly on the surface of the light receiving surface side sealing member 2a, without using the front surface protection member 4 formed from a resin film in the photovoltaic module 100 of the first embodiment, and a front surface protection layer is configured of the glass coating layer 5a and sealing member 2a, as shown in Fig. 2. As no heat resistance can be expected of the sealing member 2a, it is preferable in terms of flame resistance that the glass coating layer 5a is thickened within a range such that no flexibility is lost. In the photovoltaic module 200 of the second embodiment, mechanical strength as a module depends on the rear surface protection layer 3.

### Third Embodiment

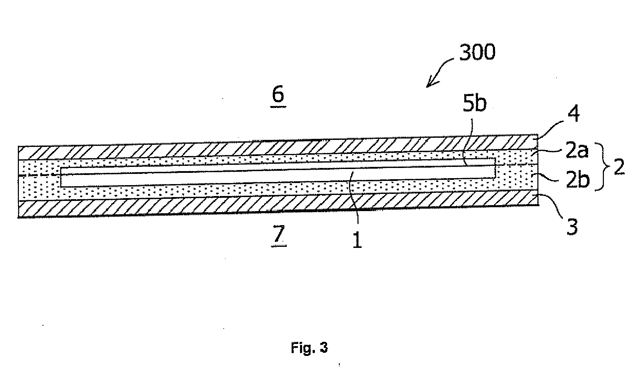

A photovoltaic module 300 of a third embodiment according to the embodiment is such that a glass coating layer 5b is formed on the light receiving surface side 6 of the photovoltaic cell 1, as shown in Fig. 3. Consequently, the glass coating layer 5b doubles as a light receiving surface side sealing member of the photovoltaic cell 1. The photovoltaic module 300 of the third embodiment is such that, after the manufacture of the photovoltaic cell 1, the glass coating material 5b is applied to the light receiving surface side 6 of the photovoltaic cell 1 and allowed to cure, after which a preliminary lamination process is carried out by stacking the sealing members 2a and 2b on the light receiving surface side and non-light receiving surface side, and subsequently, the photovoltaic module 300 can be configured by carrying out a vacuum lamination processing with the front surface protection member 4 and rear surface protection member 3 after a cutting step, in the same way as in the first embodiment.

As the front surface protection member 4 is directly exposed to flame in the photovoltaic module 300 of the third embodiment, the flame resistance of the module surface depends on the material of the front surface protection member 4, meaning that there is no difference from a heretofore known module. However, as the heat resistance of the film substrate 11 of the photovoltaic cell 1 improves, and deformation due to the heat of a flame is suppressed, by interposing the glass coating layer 5b on the light receiving surface side 6 of the photovoltaic cell 1, an improvement in flame resisting performance as a module can be expected because of this.

Although a description has been given of some embodiments of the invention, the invention is not limited to these embodiments, and various other further modifications and changes are also possible based on the technical idea of the invention.

For example, in the embodiments, a case is shown wherein the preliminary lamination processing of the sealing members 2a and 2b, and the vacuum lamination processing of the front surface protection member 4 and rear surface protection member 3, are implemented separately either side of the cutting step, but they can also be carried out simultaneously. Also, it is also possible to configure a sub-module (for example, reference numerals 1, 2, 4, and 5 in Fig. 1) having the glass coating layer 5 on the front surface thereof by carrying out sealing using a vacuum lamination process without including the rear surface protection member 3, and applying the glass coating member 5 to the outermost surface thereof, and configure a photovoltaic module by attaching the rear surface protection member 3 to the sub-module with a pressure sensitive adhesive sheet, reaction curing adhesive, or the like. In this case, a case in which the rear surface protection member is configured of the contact surface of a building, or the like, is also included.

## Claims

1. A photovoltaic module, comprising:
a substrate structure photovoltaic cell wherein a metal electrode layer, a thin film photoelectric conversion layer, and a transparent electrode layer are formed stacked on a light receiving surface side of a film substrate;
light receiving surface side and non-light receiving surface side sealing member layers stacked on a light receiving surface side and non-light receiving surface side of the photovoltaic cell, and directly joined to each other in the periphery of the photovoltaic cell, that essentially seal the photovoltaic cell;
a front surface protection layer joined to the light receiving surface side of the photovoltaic cell across the light receiving surface side sealing member layer; and
a rear surface protection layer joined to the non-light receiving surface side of the photovoltaic cell across the non-light receiving surface side sealing member layer, wherein
the front surface protection layer is formed from a glass coating layer formed on the light receiving surface side sealing member layer.

2. A photovoltaic module, comprising:
a substrate structure photovoltaic cell wherein a metal electrode layer, a thin film photoelectric conversion layer, and a transparent electrode layer are formed stacked on a light receiving surface side of a film substrate;
light receiving surface side and non-light receiving surface side sealing member layers stacked on a light receiving surface side and non-light receiving surface side of the photovoltaic cell, and directly joined to each other in the periphery of the photovoltaic cell, that essentially seal the photovoltaic cell;
a front surface protection layer joined to the light receiving surface side of the photovoltaic cell across the light receiving surface side sealing member layer; and
a rear surface protection layer joined to the non-light receiving surface side of the photovoltaic cell across the non-light receiving surface side sealing member layer, wherein
the front surface protection layer being formed from a transparent resin film, and a glass coating layer being formed on the light receiving surface of the photovoltaic cell, the front surface protection layer is joined to the light receiving surface side of the photovoltaic cell across the light receiving surface side sealing member layer and glass coating layer.

3. A photovoltaic module, comprising:
a substrate structure photovoltaic cell wherein a metal electrode layer, a thin film photoelectric conversion layer, and a transparent electrode layer are formed stacked on a light receiving surface side of a film substrate;
light receiving surface side and non-light receiving surface side sealing member layers stacked on a light receiving surface side and non-light receiving surface side of the photovoltaic cell, and directly joined to each other in the periphery of the photovoltaic cell, that essentially seal the photovoltaic cell;
a front surface protection layer joined to the light receiving surface side of the photovoltaic cell across the light receiving surface side sealing member layer;
and
a rear surface protection layer joined to the non-light receiving surface side of the photovoltaic cell across the non-light receiving surface side sealing member
layer, wherein
the front surface protection layer is formed from a transparent resin film, and a glass coating layer is formed on a light receiving surface side thereof.

4. The photovoltaic module according to one of the claims 1 to 3, wherein the glass coating layer is formed by applying a room temperature curing type glass coating material.

5. The photovoltaic module according to claim 4, wherein
the photovoltaic cell being such that a connection electrode layer is formed on the non-light receiving surface side of the film substrate, the connection electrode layer and each layer formed from the metal electrode layer, thin film photoelectric conversion layer, and transparent electrode layer on the light receiving surface side are divided into multiple unit cells in positions not mutually aligned, and connected in series via a current collection hole drilled in a region in which the transparent electrode layer is formed and a connection hole drilled in a region in which the transparent electrode layer is not formed.
